Europäisches Patentamt

European Patent Office

Office européen des brevets

(19)

(11) Numéro de publication: **0 055 640**
**B1**

(12) **FASCICULE DE BREVET EUROPEEN**

(45) Date de publication du fascicule du brevet: **13.02.85**

(51) Int. Cl.⁴: **H 01 R 9/09,** H 01 L 23/32

(21) Numéro de dépôt: **81401866.9**

(22) Date de dépôt: **25.11.81**

(54) **Dispositif de serrage pour les éléments superposés de groupes alignés, notamment pour la connexion électrique d'éléments conducteurs.**

(30) Priorité: **05.12.80 FR 8025858**

(43) Date de publication de la demande:
**07.07.82 Bulletin 82/27**

(45) Mention de la délivrance du brevet:
**13.02.85 Bulletin 85/07**

(84) Etats contractants désignés:
**CH DE FR GB IT LI NL**

(56) Documents cités:
**DE-A-1 914 398**
**DE-B-1 251 403**

(73) Titulaire: **CII HONEYWELL BULL**
**94 Avenue Gambetta**
**F-75990 Paris Cedex 20 (FR)**

(72) Inventeur: **Bonnefoy, Jean**
**94 avenue Gambetta**
**F-75020 Paris (FR)**

(74) Mandataire: **Denis, Hervé**
**94, avenue Gambetta**
**F-75020 Paris (FR)**

Courier Press, Leamington Spa, England.

EP 0 055 640 B1

## Description

L'invention concerne un dispositif de serrage pour les éléments superposés de groupes alignés et se rapporte plus particulièrement au serrage d'éléments électriquement conducteurs superposés, en vue de réaliser une connexion électrique amovible des éléments d'un même groupe entre eux.

Le serrage de deux éléments a l'avantage d'être commode, facilement amovible, relativement adaptable aux configurations des éléments et aux conditions de serrage, et de laisser les éléments pratiquement inchangés, propres à une quelconque utilisation ultérieure. Autrement, il est moins coûteux et plus fiable de relier ces deux éléments par un liant solide, tel que de la soudure.

La connexion par serrage se pratique surtout dans le domaine de l'électricité. Un dispositif de connexion bien connu de deux éléments conducteurs superposés est le serre-fils, ou serre-câbles, se présentant sous la forme d'une cosse associée à une vis de serrage. Son utilisation est cependant limitée, du fait qu'il faut autant de serre-fils que de groupes à connecter. Aussi la connexion commune de groupes alignés d'éléments conducteurs se fait elle généralement par deux brides rectilignes enserrant les groupes d'éléments dans la direction de leur alignement, au moyen de deux organes de fixation, notamment à vis, disposés aux extrémités respectives des deux brides tout en étant écartés l'un de l'autre d'une longueur donnée supérieure à celle des groupes alignés et exerçant sur les extrémités des brides une force de serrage prédéterminée. Ce dispositif de connexion est simple et peu coûteux, mais il a l'inconvénient de ne pas exercer une pression uniforme sur les éléments de chaque groupe. En effet, en ajustant les organes de fixation montés aux extrémités des deux brides pour appliquer la force de serrage voulue, les brides se comportent comme des leviers s'appuyant sur les éléments des groupes extrêmes et s'incurvant entre ceux-ci selon la force de serrage et la configuration des brides. De la sorte, ce dispositif convient mal au serrage uniforme de nombreux groupes alignés d'éléments superposés, même en employant des brides épaisses et rigides.

Or, dans le domaine de l'électronique par exemple, l'intégration sans cesse croissante des circuits conduit à la miniaturisation et à la multiplication des éléments conducteurs d'entrée-sortie des dispositifs électroniques. Par exemple, les dispositifs à circuits intégrés de haute densité présentent ordinairement, à l'heure actuelle, de l'ordre d'une cinquantaine de plots de sortie, de 70 $\mu$m de largeur et au pas de 120 $\mu$m environ, tandis que les substrats prévus pour recevoir ces dispositifs et les interconnecter sont pourvus, sur chaque côté, de 150 plots de sortie de 0,3 mm de largeur et au pas de 0,5 mm environ. Les plots des dispositifs à circuits intégrés et des substrats sont en général associés à des conducteurs de raccordement respectifs et reliés par ceux-ci à des plages de connexion disposées sur le substrat pour la connexion des dispositifs à circuits intégrés, et sur des cartes de circuits imprimés pour l'interconnexion des substrats. Puisqu'il faut exercer un effort de l'ordre de 100 grammes par contact, dans le cas où un substrat a 150 plots sur un côté de 75 mm, un effort s'élevant à 1,5 kg est à exercer uniformément sur cette longueur.

En de telles circonstances, il est évident que les serre-fils sont inapplicables et, d'autre part, il s'avère que le dispositif de serrage à brides mentionné plus haut n'assure pas la connexion fiable, avec la force souhaitée, des éléments de tous les groupes. Il faut aussi souligner le fait qu'un tel dispositif de serrage à brides n'est efficace que si les groupes d'éléments sont alignés parallèlement aux brides. Or, le dépôt par sérigraphie du réseau d'interconnexion d'un substrat nécessite autant de cuissons du substrat qu'il y a de couches conductrices et isolantes pour la solidification de ces couches. Les cuissons et refroidissements successifs ont pour effet de voiler le substrat, d'autant plus que celui-ci a une surface élevée. Il s'ensuit que les brides, droites et rigides, conviendront d'autant moins que les futurs substrats auront une surface plus grande et un réseau d'interconnexion et des plots d'entrée-sortie plus denses. D'un autre côté, la soudure des conducteurs de raccordement aussi fins et aussi rapprochés que ceux définis précédemment a le défaut de rendre très délicate toute opération ultérieure de remplacement d'un dispositif à circuits intégrés sur un substrat, ou d'un substrat sur une carte. Il faut en effet dessouder ensemble les conducteurs de raccordement, sans les déformer, tout en les maintenant également espacés et en laissant propres ces conducteurs ainsi que les plages auxquelles ils étaient soudés en vue de leur réutilisation; il faut ensuite ressouder, sans qu'il y ait altération des qualités de soudage et des éléments environnants (à cause notamment de la chaleur dégagée et propagée par les conducteurs, les plots ou les plages) et création de courts-circuits dus à des soudures chevauchantes.

L'amovibilité du dispositif de connexion des éléments conducteurs (plots, pattes de raccordement, plages) présents dans l'exemple précédent est donc un facteur important. Les dispositifs à circuits intégrés de haute densité sont actuellement des produits relativement chers, tandis que les substrats d'interconnexion sont très coûteux, si bien que leur remplacement, en vue de leur réparation et leur réutilisation, s'impose. On a vu que le serrage est apte à produire ce résultat. Mais on a montré que le serrage traditionnel à brides rigides et rectilignes est ici inapplicable.

Le document DE—B—1251 403 décrit un dispositif pour le serrage de pièces de connexion entre éléments superposés utilisant deux brides précambrées pour répartir la pression d'une manière uniforme à l'aide d'un joint élastique placé entre les brides et les pièces de connexion. Ce document ne fournit pas de données relatives à la courbure produisant la meilleure répartition de la pression le long des pièces à serrer.

L'invention remédie aux inconvénients des dispositifs de serrage antérieurs. .

Un dispositif de serrage conforme à l'invention pour les éléments superposés de groupes rangés suivant une ligne donnée est du type comprenant deux moyens de serrage formant brides enserrant lesdits groupes et deux moyens de fixation desdites brides disposés à leurs extrémités respectives en étant écartés l'un de l'autre d'une longueur donnée et exerçant sur elles une force de serrage prédéterminée, l'une au moins des dites brides possèdant à l'état libre, non contraint, une forme cambrée relativement à ladite ligne, est caractérisé en ce que la forme cambré est équivalente à la déformée élastique d'une poutre ayant initialement la forme de ladite ligne, de section uniforme et posée sur deux appuis simples distants de ladite longueur et uniformément chargée sur cette longueur d'une valeur totale correspondant sensiblement au double de celle de ladite force de serrage appliquée à chaque extrémité de la bride, de sorte que la déformation de la bride exercée par lesdits moyens de serrage pour lui donner la forme de ladite ligne produit un serrage uniforme des éléments de chaque groupe.

Les caractéristiques et avantages de l'invention ressortiront plus clairement dans la description qui suit, faite en référence aux dessins annexés.
Dans les dessins:

— la figure 1 est une vue schématique de dessus et en perspective d'un substrat d'interconnexion de dispositifs à circuits intégrés connecté à une carte de circuits imprimés au moyen de dispositifs de serrage conformes à l'invention;
— la figure 2 est une vue agrandie et en coupe faite suivant la ligne II—II de la figure 1;
— la figure 3 est une vue en coupe, faite suivant la ligne III—III de la figure 1, illustrant en détails un dispositif de serrage conforme à l'invention, à l'état de serrage;
— la figure 4 est une vue analogue à celle de la figure 3, illustrant un mode de réalisation d'un dispositif conforme à l'invention à l'état non serré;
— la figure 5 est une vue analogue à celles des figures 3 et 4, illustrant une variante de réalisation d'un dispositif conforme à l'invention à l'état non serré;
— les figures 6a et 6b sont des schémas illustrant la déformée élastique équivalente d'une bride de serrage conforme à l'invention; et
— la figure 7 est une vue en perspective d'une variante de réalisation d'un dispositif conforme à l'invention, pouvant remplacer les quatre dispositifs de serrage représentés sur la figure 1.

L'exemple servant à illustrer la structure et les avantages d'un dispositif de serrage conforme à l'invention concernera la connexion des pattes de raccordement d'un substrat d'interconnexion de dispositifs à circuits intégrés à une carte de circuits imprimés, étant donné que les inconvénients des dispositifs de serrage antérieurs ont été présentés précédemment dans le cadre d'une telle connexion. Cet exemple illustrera donc bien les avantages principaux de l'invention.

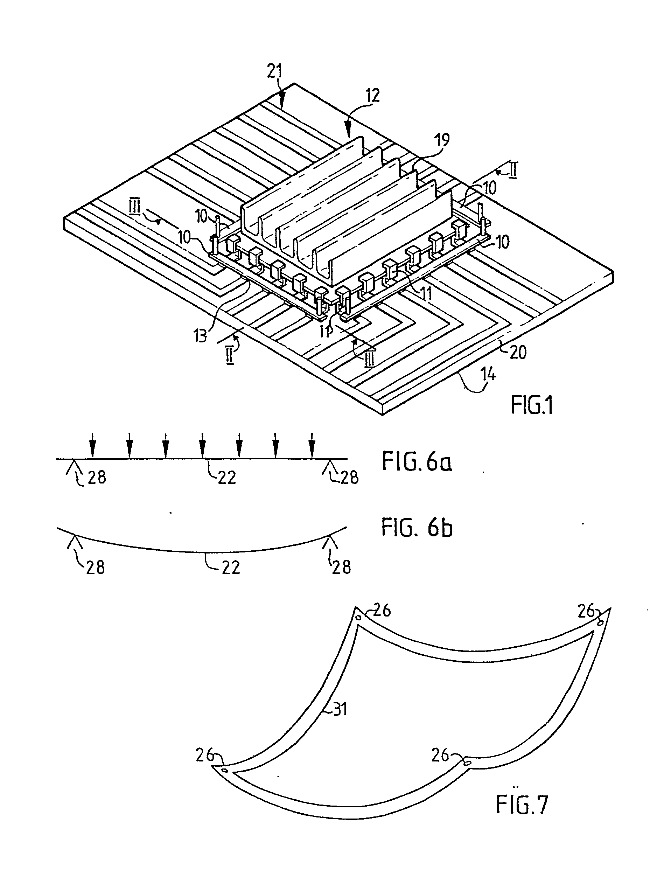

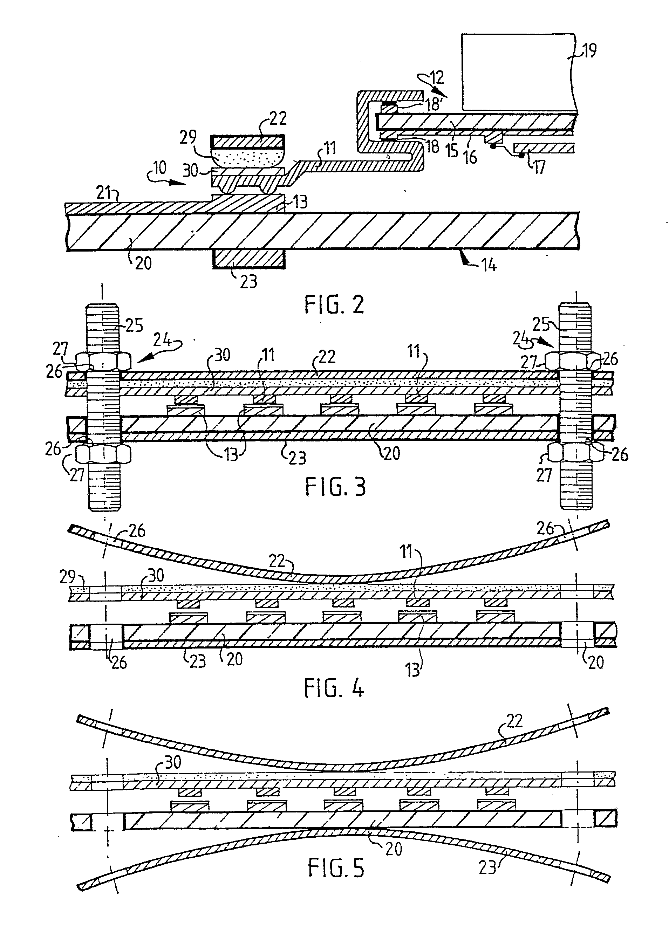

La figure 1 illustre en perspective un mode de réalisation conforme à l'invention de quatre dispositifs de serrage identiques (10) connectant, comme cela ressort mieux de la figure 2, les pattes de raccordement (11) d'un substrat (12) aux plages de connexion (13) correspondantes d'une carte de circuits imprimés (14) (illustrée à la figure 1 sous forme partielle) servant à interconnecter les substrats (12) entre eux ainsi qu'à des bornes d'entrée-sortie, non illustrées.

Le substrat (12) tel que représenté sur les figures 1 et 2 comprend une plaque de support (15), dont une face présente un réseau d'interconnexion (16) sous forme de circuits imprimés, reliant des dispositifs à circuits intégrés (17) entre eux ainsi qu'à des plots d'entrée-sortie (18), et dont l'autre face comporte un radiateur à aillettes (19) pour la dissipation thermique des calories engendrées dans les dispositifs à circuits intégrés (17). Les pattes de raccordement (11) sont soudées par une de leurs extrémités aux plots (18) ainsi qu'à des plots correspondants (18') isolés électriquement sur l'autre face de la plaque de support (15).

La carte de circuits imprimés (14) comprend une plaque de support (20) pourvue d'un réseau d'interconnexion (21) sous forme de circuits imprimés, comportant les plages de connexion (13), notamment.

Les figures 2 et 3 illustrent en grand détail un exemple de réalisation d'un dispositif de serrage (10) conforme à l'invention, respectivement en coupe transversale et en coupe longitudinale. Le serrage des pattes (11) contre les plages (13) est fait au moyen du dispositif (10) comprenant deux brides (22, 23) pourvues de deux moyens de fixation (24) de ces brides, disposés à leurs extrémités respectives en étant écartés l'un de l'autre d'une longueur donnée et exerçant sur elles une force de serrage prédéterminée. Dans l'exemple illustré, les moyens de fixation comprennent des tiges filetées (25) traversant les extrémités des brides (22) et (23) au travers d'orifices (26) et étant pourvus d'écrous (27) qui exerçant sur les extrémités des brides une force de serrage prédéterminée.

La figure 4 illustre la caractéristique essentielle de l'invention, qui réside dans le fait que l'une des brides (22) a une forme cambrée relativement à la ligne formée par les groupes des éléments (12) et (13), cette ligne étant droite dans l'exemple illustré, et comme représenté schématiquement sur les figures 6a et 6b, la forme cambrée de la bride (22) est équivalente à la déformée élastique d'une poutre ayant initialement la forme de la ligne formée par les éléments (une ligne droite dans l'exemple illustré) de section uniforme et posée sur deux appuis (28) distants sensiblement de la même longueur séparant les moyens de fixation (25) et uniformément chargée sur cette longueur d'une valeur totale correspondant sensiblement au double de celle de la force de serrage appliquée à chaque extrémité de la bride par les moyens (25). La forme de la courbe prise par la bride (22) correspond donc à une chaînette. La déformation de la bride (22) exercée par les moyens de fixation (24) afin de lui donner la forme rectiligne de l'alignement des éléments (11) et (13) assure un serrage uniforme de tous les éléments (11, 13) de chaque paire entre eux.

A la figure 4, la bride (23) épouse la forme de l'alignement des éléments (11 et 13). A ce titre, elle n'est là que pour servir de surface de réaction d'appui suffisante pour exercer la force de serrage prédéterminée. Par conséquent, dans le cas où la plaque de support (20) de la carte (14) a une rigidité suffisante pour pouvoir supporter sans dommage la force de serrage, cette plaque (20) peut faire office de la bride (23), celle-ci pouvant donc être supprimée.

Par contre, il peut s'avérer intéressant de donner aux deux brides (22) et (23) la même forme cambrée que celle de la bride (22) représentée sur la figure 4, comme cela est illustré dans la figure 5. L'intérêt réside dans l'assurance d'avoir une pression de serrage uniforme due à l'action des déformations concommitantes des brides (22) et (23). En effet, dans le dispositif représenté sur la figure 4, la bride (23) peut subir des contraintes risquant de l'incurver, de sorte que l'action de serrage uniforme produit par la bride (22) peut être altérée à certains endroits à cause de la défaillance de la surface de réaction d'appui formée par la plaque (20) et la bride (23).

Comme représenté sur les figures 2 à 5, il peut s'avérer profitable d'interposer un joint souple (29) entre la bride (22) et la suite d'éléments, tels que les pattes (11) dans l'exemple illustré. Ce joint souple permet d'absorber les efforts dus au fait que la ligne des groupes d'éléments (11) et (13) peut ne pas être parfaitement droite, que les épaisseurs des éléments (11) et (13) d'un même groupe peuvent varier de groupes à autres, notamment. En d'autres termes, le joint (29) répartit avantageusement la force de serrage sur l'ensemble des groupes d'éléments (11) et (13).

Par ailleurs, étant donné que les pattes de raccordement sont des éléments très fins et très fragiles, il pourra être avantageux de maintenir leur écartement désiré au moyen d'une bande rigide (30), fixée aux éléments (11) correspondants.

Comme représenté sur la figure 7, l'ensemble des quatre brides (22) ou des quatre brides (23) des dispositifs de serrage (10) représentés sur la figure 1 peut être formé d'une seule pièce (31). Plus généralement lorsque le substrat (12) est pourvu de pattes sur des côtés adjacents, les brides correspondantes peuvent être formées d'une seule pièce. Dans le cas où les moyens de fixation (24) sont formés à base de tiges filetées, la pièce (31) sera pourvue d'orifice (26) correspondants. Bien entendu, les moyens de fixation (24) peuvent être formés par d'autres moyens, tels que par exemple des clips, etc....

Il ressort de la description qui précède qu'un dispositif de serrage conforme à l'invention peut être adapté à la connexion entre éléments quelconques disposés en groupes suivant une ligne de forme quelconque, les principes de cambrures d'une des brides au moins restant les mêmes et les effets résultant de leur déformation également.

Il est à noter aussi qu'un même dispositif (10) ou (31) peut s'appliquer à la connexion des pattes de raccordement de dispositifs à circuits intégrés (17) de grandes dimensions à la plaque de support (15) du substrat (12).

**Revendications**

1. Dispositif de serrage (10) pour les éléments superposés (11, 13) de groupes rangés suivant une ligne donnée, du type comprenant deux moyens de serrage formant brides (22, 23) enserrant lesdits groupes et deux moyens de fixation (24) desdites brides disposés à leurs extrémités respectives en étant écartés l'un de l'autre d'une longueur donnée et exerçant sur elles une force de serrage prédéterminée, l'une (22) au moins desdites brides possèdant à l'état libre, non contraint, une forme cambrée relativement à ladite ligne caractérisé en ce que, la forme cambrée est équivalente à la déformée élastique d'une poutre ayant initialement la forme de ladite ligne, de section uniforme et posée sur deux appuis simples (28) distants de ladite longueur et uniformément chargée sur cette longueur d'une valeur totale correspondant sensiblement au double de celle de ladite force de serrage appliquée à chaque extrémité de la bride, de sorte que la déformation de la bride exercée par lesdits moyens de fixation (24) pour lui donner la forme de ladite ligne produit un serrage uniforme des éléments de chaque groupe.

2. Dispositif selon la revendication 1, caractérisé en ce qu'un joint souple (29) est interposé entre au moins l'une (22) des brides et les éléments correspondants (11) desdits groupes.

3. Dispositif selon la revendication 1 ou 2, caractérisé en ce qu'une bande rigide (30) est fixée aux éléments correspondants à une bride de manière à maintenir l'écartement désiré entre eux.

4. Dispositif selon l'une quelconque des revendications 1 à 3, caractérisé en ce que chaque groupe comprend, comme premier élément, une patte de raccordement (11) d'une première plaque à circuits imprimés (12) ou d'un dispositif électronique et, comme second élément, un plot ou plage de connexion (13) d'une seconde plaque à circuits imprimés (14, 20).

5. Dispositif selon la revendication 4, caractérisé en ce que l'une (20) desdites brides est constituée par l'une desdites plaques de circuits imprimés.

6. Dispositif selon la revendication 4 ou 5, caractérisé en ce que ledit dispositif électronique ou ladite première plaque étant pourvu de pattes de raccordement sur des côtés adjacents, lesdites brides correspondantes sont formées d'une seule pièce (31).

**Patentansprüche**

1. Spannvorrichtung (10) für die übereinanderliegenden Elemente (11, 13) von Gruppen, die längs einer gegebenen Linie geordnet sind, vom Typ mit zwei Spannmitteln in Form von Leisten (22, 23), welche die genannten Gruppen einspannen, und mit zwei Befestigungsmitteln (24) zur Befestigung der genannten Leisten, welche jeweils an einem ihrer Enden angeordnet sind und voneinander einen gegebenen Abstand aufweisen sowie eine vorbestimmte Spannkraft auf sie ausüben, wobei wenigstens eine (22) der Leisten im freien, unbeanspruchten Zustand eine bogenartig gekrümmte Form relativ zu der genannten Linie aufweist, dadurch gekennzeichnet, daß die bogenartig gekrümmte Form äquivalent einer elastischen Deformierung eines Balkens ist, der anfänglich die Form der genannten Linie aufweist, einen gleichförmigen Querschnitt besitzt und auf zwei einfachen, um die genannte Länge beabstandeten Abstützungen (28) aufliegt sowie über diese Länge hinweg gleichförmig mit einem Gesamtwert belastet ist, der im wesentlichen dem Doppelten des Wertes der genannten Spannkraft entspricht, die auf jedes freie Ende der Leiste ausgeübt wird, so daß die durch die genannten Befestigungsmittel (24) ausgeübte Deformierung, um ihr die Form der genannten Linie zu verleihen, eine gleichförmige Verspannung der Elemente jeder Gruppe hervorruft.

2. Vorrichtung nach Anspruch 1, dadurch gekennzeichnet, daß ein nachgiebiges Zwischenstück (29) zwischen wenigstens einer der Leisten (22) und den entsprechenden Elementen (11) der Gruppen angeordnet ist.

3. Vorrichtung nach Anspruch 1 oder 2, dadurch gekennzeichnet, daß ein steifes Band (30) an den entsprechenden Enden einer Leiste derart befestigt ist, daß der gewünschte Abstand dazwischen aufrechterhalten bleibt.

4. Vorrichtung nach einem der Ansprüche 1 bis 3, dadurch gekennzeichnet, daß jede Gruppe als erstes Element eine Anschlußzunge (11) einer ersten gedruckten Schaltungsplatte (12) oder einer elektronischen Vorrichtung und als zweites Element ein Klötzchen oder eine Anschlußfläche (13) einer zweiten gedruckten Schaltungsplatte (14, 20) umfaßt.

5. Vorrichtung nach Anspruch 4, dadurch gekennzeichnet, daß eine (20) der genannten Leisten aus einer der genannten Flächen von gedruckten Schaltungen besteht.

6. Vorrichtung nach Anspruch 4 oder 5, dadurch gekennzeichnet, daß die genannte elektronische Vorrichtung oder die genannte erste Platte mit Anschlußzungen an den nebeneinanderliegenden Seiten versehen ist, und die genannten entsprechenden Leisten aus einem einzigen Teil (31) gebildet sind.

**Claims**

1. A clamping device (10) for the superposed elements (11, 13) of groups ranged along a given line, of the kind comprising two clamping means forming straps (22, 23) enclamping the said groups and two means (24) for fastening the said straps situated at their respective extremities whilst being spaced apart from each other by a given length and exerting a predetermined clamping force on the same, one (22) of the said straps having a curved shape with respect to the said line whilst in the free and unconstrained state, characterised in that the curved shape is equivalent to the elastic deformation of a beam initially having the form of the said line, of uniform cross-section and placed on two simple supports (28) spaced apart by the said length and loaded uniformly over this length to a total value corresponding substantially to twice that of the said clamping force applied to each extremity of the strap, so that the deformation of the strap caused by the said fastening means (24) in order to endow it with the shape of the said line, induces a uniform clamping of the elements of each group.

2. A device according to claim 1, characterised in that a flexible joint (29) is interposed between at least one (22) of the straps and the corresponding elements (11) of the said groups.

3. A device according to claim 1 or 2, characterised in that a rigid strip (30) is secured to the elements corresponding to a strap in a manner such as to maintain the required spacing between them.

4. A device according to any one of claims 1 to 3, characterised in that each group comprises, as a first element, a connecting tab (11) of a first printed circuit board (12) or of an electronic device, and as a second element, a contact or connection area (13) of a second printed circuit board (14, 20).

5. A device according to claim 4, characterised in that one (20) of the said straps is formed by one of said printed circuit boards.

6. A device according to claim 4 or 5, characterised in that the said electronic device or the said first board being equipped with connecting tabs on adjacent sides, the said corresponding straps are formed in one piece (31).

0 055 640

FIG.1

FIG.6a

FIG. 6b

FIG.7

1

FIG. 2

FIG. 3

FIG. 4

FIG. 5